# EUROPÄISCHE PATENTANMELDUNG

(11) **EP 3 826 443 A1**
(43) Veröffentlichungstag der Anmeldung: **26.05.2021**
(21) Anmeldenummer: 20209635.0
(22) Anmeldetag: 24.11.2020
(51) Int. Cl.: H05K 7/20

(54) **STROMRICHTER**

(30) Priorität: 25.11.2019 DE 102019218209
(71) Anmelder: Schmidhauser AG, 8590 Romanshorn (CH)
(72) Erfinder: Fässler, Benjamin, 9104 Waldstatt (CH); Hoffmann, Ewgeni, 31855 Aerzen (DE); Schneggenburger, Christof, 8594 Güttingen (CH)
(74) Vertreter: Patentanwälte Ruff, Wilhelm, Beier, Dauster & Partner mbB

(57) **Zusammenfassung**

Stromrichter (1), aufweisend:
- eine Leiterplatte (2),
- ein erstes wärmeerzeugendes Bauelement (3), das auf der Leiterplatte (2) angeordnet ist und das eine erste Bauhöhe (H1) über der Leiterplatte (2) aufweist, und
- ein zweites wärmeerzeugendes Bauelement (4), das auf der Leiterplatte (2) angeordnet ist und das eine zweite Bauhöhe (H2) über der Leiterplatte (2) aufweist, wobei die zweite Bauhöhe (H2) größer als die erste Bauhöhe (H1) ist, und
- einen Kühlkörper (5), wobei eine dem ersten wärmeerzeugenden Bauelement (3) und dem zweiten wärmeerzeugenden Bauelement (4) zugewandte Kontaktseite (6) des Kühlkörpers (5) derart geformt ist, dass sowohl das erste wärmeerzeugende Bauelement (3) als auch das zweite wärmeerzeugende Bauelement (4) mit der Kontaktseite (6) des Kühlkörpers (5) wärmeleitend koppelbar sind.

## Beschreibung

Die Erfindung betrifft einen Stromrichter in Form einer Netzrückspeiseeinheit oder eines Frequenzumrichters. Eine Netzrückspeiseeinheit speist elektrische Energie/Leistung, die beispielsweise in einem Zwischenkreis vorhanden ist, in ein Versorgungsnetz zurück. Im Übrigen sei auch auf die einschlägige Fachliteratur verwiesen.

Der Erfindung liegt die Aufgabe zugrunde, einen Stromrichter in Form einer Netzrückspeiseeinheit oder eines Frequenzumrichters zur Verfügung zu stellen, der einfach und kostengünstig herstellbar ist und der eine hohe Kühlleistung aufweist.

Der Stromrichter in Form der Netzrückspeiseeinheit oder des Frequenzumrichters weist eine Leiterplatte auf.

Ein erstes wärmeerzeugendes Bauelement ist auf der Leiterplatte angeordnet, wobei das erste wärmeerzeugende Bauelement eine erste Bauhöhe über der Leiterplatte aufweist. Das erste wärmeerzeugende Bauelement kann beispielsweise ein Leistungshalbleitermodul mit mehreren IGBTs sein, die beispielsweise einen 3-brückigen Wechselrichter bilden. Alternativ kann das erste wärmeerzeugende Bauelement beispielsweise auch ein Leistungshalbleiter eines DC/DC-Wandlers, usw. sein.

Ein zweites wärmeerzeugendes Bauelement ist auf derselben Seite der Leiterplatte angeordnet, wie das erste wärmeerzeugende Bauelement. Das zweite wärmeerzeugende Bauelement weist eine zweite Bauhöhe über der Leiterplatte auf, wobei die zweite Bauhöhe größer als die erste Bauhöhe ist. Das zweite wärmeerzeugende Bauelement kann beispielsweise eine Gleichrichterdiode, usw. sein.

Der Stromrichter weist weiter einen, insbesondere metallischen, Kühlkörper auf, wobei eine dem ersten wärmeerzeugenden Bauelement und dem zweiten wärmeerzeugenden Bauelement zugewandte Kontaktseite des Kühlkörpers derart geometrisch geformt ist, dass sowohl das erste wärmeerzeugende Bauelement als auch das zweite wärmeerzeugende Bauelement mit der Kontaktseite des Kühlkörpers wärmeleitend gekoppelt sind.

Gemäß einer Ausführungsform ist der Kühlkörper derart geformt und/oder relativ zur Leiterplatte ausgerichtet, dass ein Abstand zwischen der Kontaktseite und der Leiterplatte im Bereich des ersten wärmeerzeugenden Bauelements kleiner ist als ein Abstand zwischen der Kontaktseite und der Leiterplatte im Bereich des zweiten wärmeerzeugenden Bauelements. Insbesondere entspricht der Abstand zwischen der Kontaktseite und der Leiterplatte im Bereich des ersten wärmeerzeugenden Bauelements der ersten Bauhöhe und der Abstand zwischen der Kontaktseite und der Leiterplatte im Bereich des zweiten wärmeerzeugenden Bauelements entspricht der zweiten Bauhöhe.

Gemäß einer Ausführungsform weist der Kühlkörper ein, insbesondere stufenförmiges bzw. einstufiges, Höhenprofil derart auf, dass ein Abstand zwischen der Kontaktseite und der Leiterplatte im Bereich des ersten wärmeerzeugenden Bauelements kleiner ist als ein Abstand zwischen der Kontaktseite und der Leiterplatte im Bereich des zweiten wärmeerzeugenden Bauelements. Insbesondere entspricht der Abstand zwischen der Kontaktseite und der Leiterplatte im Bereich des ersten wärmeerzeugenden Bauelements der ersten Bauhöhe und der Abstand zwischen der Kontaktseite und der Leiterplatte im Bereich des zweiten wärmeerzeugenden Bauelements entspricht der zweiten Bauhöhe.

Gemäß einer Ausführungsform weist der Kühlkörper auf einer der Kontaktseite gegenüberliegenden Seite Kühlrippen auf.

Gemäß einer Ausführungsform weist der Stromrichter weitere wärmeerzeugende Bauelemente auf, die mit einer Seite des Kühlkörpers wärmeleitend gekoppelt sind, die senkrecht auf die Kontaktseite steht.

Gemäß einer Ausführungsform begrenzen der Kühlkörper und das zweite wärmeerzeugende Bauelement einen Raum, gegebenenfalls zusammen mit weiteren Komponenten des Stromrichters, wobei in den Raum weitere auf der Leiterplatte angeordnete Bauelemente hinein ragen.

Gemäß einer Ausführungsform weist der Kühlkörper im Bereich des Raums Durchgangsöffnungen auf, die eine Luftströmung in den/dem Raum ermöglichen, und so eine wirksamere Kühlung der in den Raum hinein ragenden Bauelemente ermöglichen.

Gemäß einer Ausführungsform verlaufen die Leiterplatte und die Kontaktseite des Kühlkörpers zumindest abschnittsweise planparallel.

Gemäß einer Ausführungsform weist der Stromrichter weiter auf: ein Gehäuse mit Gehäuseöffnungen auf gegenüberliegenden Seiten des Gehäuses, und einen Lüfter, der dazu ausgebildet ist, einen Luftstrom zwischen den Gehäuseöffnungen auf den gegenüberliegenden Seiten des Gehäuses entlang des Kühlkörpers, insbesondere entlang von Kühlrippen des Kühlkörpers, bzw. durch den Kühlkörper zu bewirken.

Die Erfindung wird nachfolgend unter Bezugnahme auf die Zeichnungen detailliert beschrieben. Hierbei zeigt:
- Fig. 1: hoch schematisch einen Querschnitt eines erfindungsgemäßen Stromrichters,
- Fig. 2: hoch schematisch eine perspektivische Ansicht des Stromrichters von Fig. 1,
- Fig. 3: eine weitere, detailliertere perspektivische Ansicht des Stromrichters von Fig. 1,
- Fig. 4: eine detailliertere perspektivische Ansicht in ein Gehäuseinneres des erfindungsgemäßen Stromrichters und
- Fig. 5: eine weitere perspektivische Ansicht in das Gehäuseinnere des erfindungsgemäßen Stromrichters.

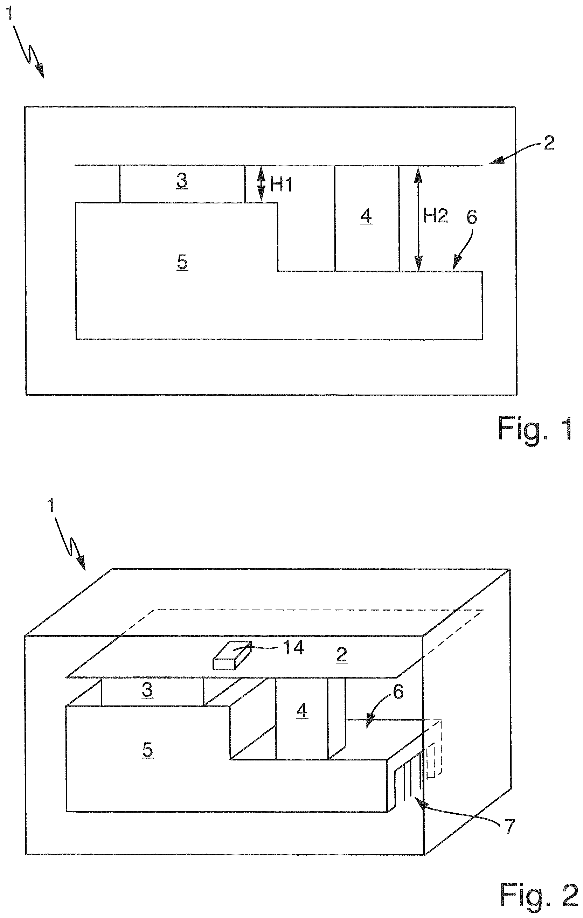

Fig. 1 zeigt hoch schematisch einen Querschnitt eines erfindungsgemäßen Stromrichters 1, beispielsweise in Form eines Frequenzumrichters oder einer Netzrückspeiseeinheit.

Der Stromrichter 1 weist eine Leiterplatte 2 auf.

Auf der Leiterplatte 2 ist ein erstes wärmeerzeugendes Bauelement 3 angeordnet, das eine erste Bauhöhe H1 über der Leiterplatte 2 aufweist.

Auf der Leiterplatte 2 ist ein zweites wärmeerzeugendes Bauelement 4 angeordnet, das eine zweite Bauhöhe H2 über der Leiterplatte 2 aufweist.

Der Stromrichter 1 weist einen Kühlkörper 5 auf, wobei eine dem ersten wärmeerzeugenden Bauelement 3 und dem zweiten wärmeerzeugenden Bauelement 4 zugewandte Kontaktseite 6 des Kühlkörpers 5 derart stufenförmig geformt ist, dass sowohl das erste wärmeerzeugende Bauelement 3 als auch das zweite wärmeerzeugende Bauelement 4 mit der Kontaktseite 6 des Kühlkörpers 5 wärmeleitend koppelbar und gekoppelt sind.

Hierzu ist der Kühlkörper 5 derart geformt und planparallel zur Leiterplatte 2 angeordnet, dass ein Abstand zwischen der Kontaktseite 6 und der Leiterplatte 2 im Bereich des ersten wärmeerzeugenden Bauelements 3 kleiner ist als ein Abstand zwischen der Kontaktseite 6 und der Leiterplatte 2 im Bereich des zweiten wärmeerzeugenden Bauelements 4. Der Abstand zwischen der Kontaktseite 6 und der Leiterplatte 2 im Bereich des ersten wärmeerzeugenden Bauelements 3 entspricht der ersten Bauhöhe H1 und der Abstand zwischen der Kontaktseite 6 und der Leiterplatte 2 im Bereich des zweiten wärmeerzeugenden Bauelements 4 entspricht der zweiten Bauhöhe H2.

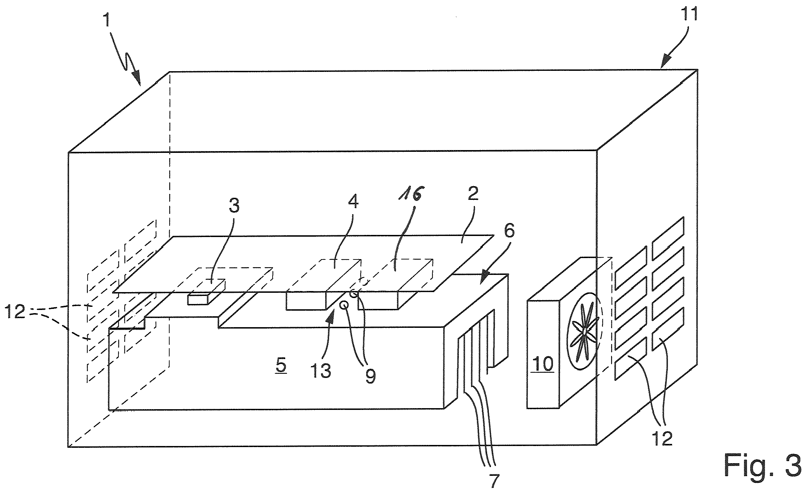

Bezug nehmend auf die Figuren 2 und 3 weist der Kühlkörper 5 auf einer der Kontaktseite 6 gegenüberliegenden Seite Kühlrippen 7 auf.

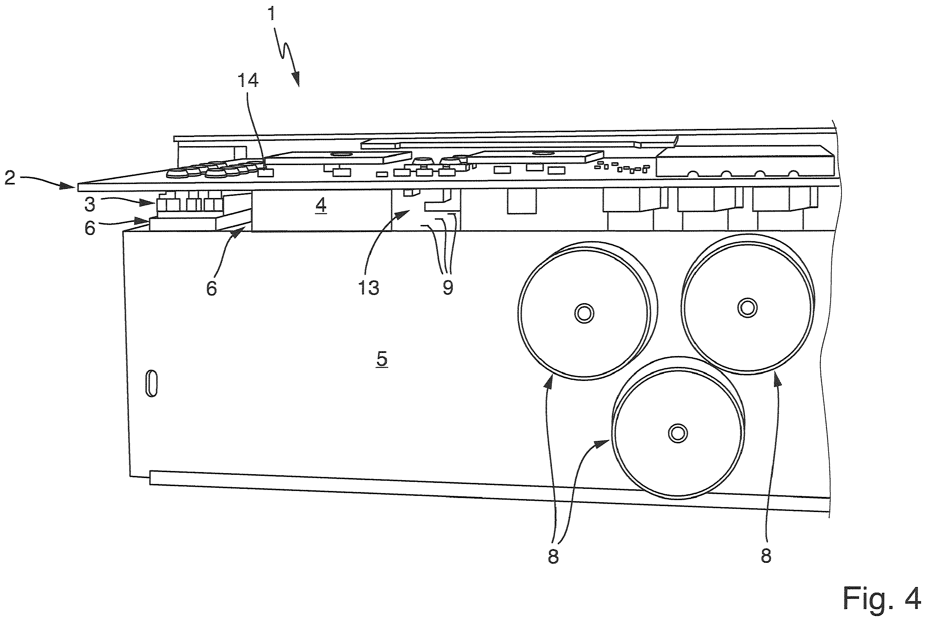

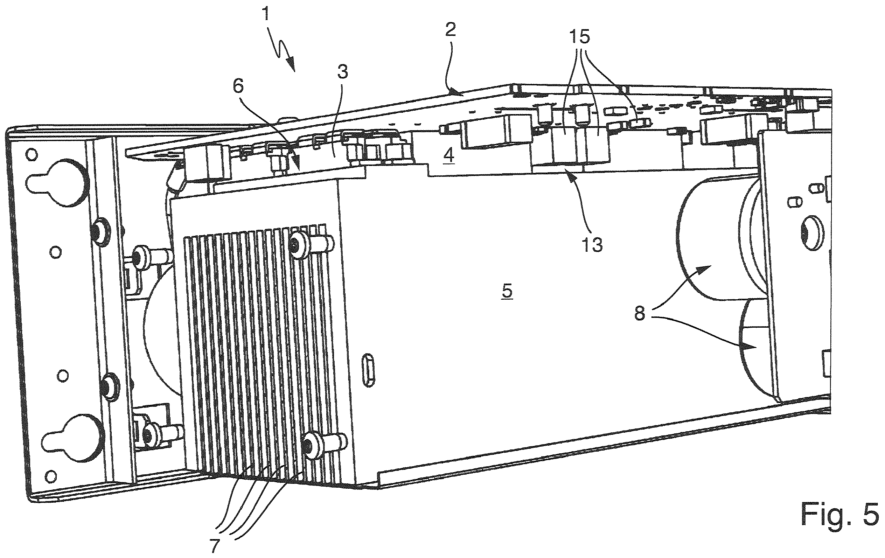

Bezug nehmend auf die Figuren 4 und 5 weist der Stromrichter 1 weitere wärmeerzeugende Bauelemente 8 auf, die mit einer Seite des Kühlkörpers 5 wärmeleitend gekoppelt sind, die senkrecht auf die Kontaktseite 6 steht. Die Bauelemente 8 sind auf einer weiteren Leiterplatte angeordnet bzw. elektrisch kontaktiert, die senkrecht zu der Leiterplatte 2 angeordnet ist.

Bezug nehmend auf die Figuren 3 bis 5 begrenzen der Kühlkörper 5 und das zweite wärmeerzeugende Bauelement 4 einen Raum 13, in den weitere auf der Leiterplatte 2 angeordnete Bauelemente 15 ragen, wobei der Raum 13 thermisch abgeschirmt von den stark wärmeerzeugenden Bauelementen 3 und 4 ist.

Bezug nehmend auf die Figuren 3 und 4 weist der Kühlkörper 5 im Bereich des Raums 13 Durchgangsöffnungen 9 auf, die eine Luftströmung in dem Raum 13 und damit die Kühlung der Bauelemente 15 verbessern. Die Durchgangsöffnungen 9 leiten Kühlluft von einem Kühlluftkanal des Kühlkörpers, in dem die Kühlrippen 7 angeordnet sind insbesondere in Richtung des zweiten wärmeerzeugenden Bauelements 4, so dass dieses effektiv gekühlt wird. Hierzu sind die Durchgangsöffnungen 9 neben bzw. nahe dem zweiten wärmeerzeugenden Bauelement 4 angeordnet.

Bezug nehmend auf Fig. 3 weist der Stromrichter 1 weiter ein Gehäuse 11 mit Gehäuseöffnungen 12 auf gegenüberliegenden Seiten des Gehäuses 11 und einen Lüfter 10 auf, der dazu ausgebildet ist, einen Luftstrom zwischen den Gehäuseöffnungen 12 auf den gegenüberliegenden Seiten des Gehäuses 11 entlang des Kühlkörpers 5 zu bewirken.

Auf einer den Bauelementen 3, 4 und 15 abgewandten Seite der Leiterplatte 2 sind weitere Bauelemente 14 angeordnet.

Es können weitere wärmeerzeugende Bauelemente vorgesehen sein. Vorliegend ist exemplarisch ein einzelnes weiteres wärmeerzeugendes Bauelement mit dem Bezugszeichen 16 vorgesehen. Das weitere wärmeerzeugende Bauelement 16 ist bezogen auf die Durchgangsöffnungen 9 und das zweite wärmeerzeugende Bauelement 4 derart angeordnet, dass die Durchgangsöffnungen 9, insbesondere mittig, zwischen dem zweiten wärmeerzeugenden Bauelement 4 und dem weiteren wärmeerzeugenden Bauelement 16 angeordnet sind.

Die Figur 3 bis 5 zeigen, dass die Kontaktseite 6 nur eine lokal begrenzte Erhöhung im Bereich des ersten wärmeerzeugenden Bauelements 3 aufweist, insbesondere in Form eines Podests.

## Patentansprüche

1. Stromrichter (1) in Form einer Netzrückspeiseeinheit oder eines Frequenzumrichters, aufweisend:
- eine Leiterplatte (2),
- ein erstes wärmeerzeugendes Bauelement (3), das auf der Leiterplatte (2) angeordnet ist und das eine erste Bauhöhe (H1) über der Leiterplatte (2) aufweist, und
- ein zweites wärmeerzeugendes Bauelement (4), das auf der Leiterplatte (2) angeordnet ist und das eine zweite Bauhöhe (H2) über der Leiterplatte (2) aufweist, wobei die zweite Bauhöhe (H2) größer als die erste Bauhöhe (H1) ist, und
- einen Kühlkörper (5), wobei eine dem ersten wärmeerzeugenden Bauelement (3) und dem zweiten wärmeerzeugenden Bauelement (4) zugewandte Kontaktseite (6) des Kühlkörpers (5) derart geformt ist, dass sowohl das erste wärmeerzeugende Bauelement (3) als auch das zweite wärmeerzeugende Bauelement (4) mit der Kontaktseite (6) des Kühlkörpers (5) wärmeleitend koppelbar sind.

2. Stromrichter (1) nach Anspruch 1, **dadurch gekennzeichnet, dass**
- der Kühlkörper (5) derart geformt und relativ zur Leiterplatte (2) angeordnet ist, dass ein Abstand (H1) zwischen der Kontaktseite (6) und der Leiterplatte (2) im Bereich des ersten wärmeerzeugenden Bauelements (3) kleiner ist als ein Abstand (H2) zwischen der Kontaktseite (6) und der Leiterplatte (2) im Bereich des zweiten wärmeerzeugenden Bauelements (4).

3. Stromrichter (1) nach Anspruch 1 oder 2, **dadurch gekennzeichnet, dass**
- der Kühlkörper (5) ein Höhenprofil derart aufweist, dass ein Abstand (H1) zwischen der Kontaktseite (6) und der Leiterplatte (2) im Bereich des ersten wärmeerzeugenden Bauelements (3) kleiner ist als ein Abstand (H2) zwischen der Kontaktseite (6) und der Leiterplatte (2) im Bereich des zweiten wärmeerzeugenden Bauelements (4).

4. Stromrichter (1) nach einem der vorhergehenden Ansprüche, **dadurch gekennzeichnet, dass**
- der Kühlkörper (5) auf einer der Kontaktseite (6) gegenüberliegenden Seite Kühlrippen (7) aufweist.

5. Stromrichter (1) nach einem der vorhergehenden Ansprüche, **dadurch gekennzeichnet, dass**
- der Stromrichter (1) weitere wärmeerzeugende Bauelemente (8) aufweist, die mit einer Seite des Kühlkörpers (5) wärmeleitend gekoppelt sind, die senkrecht auf die Kontaktseite (6) steht.

6. Stromrichter (1) nach einem der vorhergehenden Ansprüche, **dadurch gekennzeichnet, dass**
- der Kühlkörper (5) und das zweite wärmeerzeugende Bauelement (4) einen Raum (13) begrenzen, in den weitere auf der Leiterplatte (2) angeordnete Bauelemente (15) ragen.

7. Stromrichter (1) nach Anspruch 6, **dadurch gekennzeichnet, dass**
- der Kühlkörper (5) im Bereich des Raums (13) Durchgangsöffnungen (9) aufweist.

8. Stromrichter (1) nach einem der vorhergehenden Ansprüche, **dadurch gekennzeichnet, dass**
- die Leiterplatte (2) und die Kontaktseite (6) des Kühlkörpers (5) zumindest abschnittsweise planparallel verlaufen.

9. Stromrichter (1) nach einem der vorhergehenden Ansprüche, **dadurch gekennzeichnet, dass**
- der Stromrichter (1) weiter aufweist:
- ein Gehäuse (11) mit Gehäuseöffnungen (12) auf gegenüberliegenden Seiten des Gehäuses (11), und
- einen Lüfter (10), der dazu ausgebildet ist, einen Luftstrom zwischen den Gehäuseöffnungen (12) auf den gegenüberliegenden Seiten des Gehäuses (11) entlang des Kühlkörpers (5) zu bewirken.
